# EUROPEAN PATENT APPLICATION

(11) **EP 0 727 934 A1**
(43) Date of publication of application: **21.08.1996**
(21) Application number: 96300927.9
(22) Date of filing: 12.02.1996
(51) Int. Cl.: H05K 13/04

(54) **Suction nozzle device for work mounting machine**

(30) Priority: 17.02.1995 JP 29626/95
(71) Applicant: Japan Tobacco Inc., Minato-Ku Tokyo 105 (JP); KABUSHIKI KAISHA TOSHIBA, Kawasaki-shi, Kanagawa-ken 210 (JP)
(72) Inventor: Suzuki, Hisao, c/o Japan Tobacco Inc., Kita-ku, Tokyo (JP); Yamada, Manabu, c/o Japan Tobacco Inc., Kita-ku, Tokyo (JP); Taira, Koji, c/o Kabushiki Kaisha Toshiba, Mie-gun, Mie (JP)
(74) Representative: Ruffles, Graham Keith

(57) **Abstract**

The suction nozzle device for a chip mounter is provided with a suction nozzle (16) which travels from a part feeder toward a printed board with repeating a cycloid motion. The suction nozzle (16) has a nozzle tip (56) for taking up a part (P) from the part feeder under suction. This nozzle tip (56) is formed of a metal inner pipe (58) and a transparent outer pipe (60) surrounding this inner pipe (58). The suction nozzle device is further provided with a camera which catches silhouette of the part (P) in the course that the part (P) sucked up by the nozzle tip (56) is transported toward the printed board.

## Description

### BACKGROUND OF THE INVENTION

### Field of the Invention

The present invention relates to a work mounting machine for mounting electric or electronic parts onto a printed board, more particularly to a suction nozzle device which is used for taking up a part from a part feeder and mounting the part onto the printed board.

### Description of the Related Art

Such type of work mounting machine is disclosed, for example, in U.S. Patent No. 5,417,542. This known work mounting machine is provided with a predetermined transportation path and a suction nozzle which travels along the transportation path with repeating vertical movement to give a cycloid motion. On the transportation path are arranged part feeders and a printed board. The part feeders and the printed board are spaced from each other along the path, and the printed board is loaded on an XY table.

When the suction nozzle makes the cycloid motion to reach one of the part feeders, the tip of the suction nozzle or the nozzle tip sucks up a part in the part feeder, and thus the part is taken up from the part feeder. Subsequently, the sucked part is transported together with the suction nozzle toward the printed board, and it is released from the suction nozzle at a target position on the printed board when the sucked part reaches the printed board.

It is difficult to align the center of the part with the axis of the nozzle tip when the part is sucked up to the nozzle tip of the suction nozzle, and the center of the sucked part is liable to deviate from the axis of the nozzle tip. Accordingly, when the part is to be mounted from the suction nozzle onto the printed board at the target position, the center of the part, rather than the axis of the nozzle tip, must be aligned with the target position.

The center of the part is detected in the course that the part sucked up by the suction nozzle is transported toward the printed board. Specifically, an image pickup unit is disposed below the transportation path to be situated between the part feeders and the printed board. The image pickup unit catches the silhouette of the part when the part sucked up by the suction nozzle passes over it. In order to enable picking up of image, light is irradiated from the suction nozzle side against the part sucked up by the nozzle tip, and thus the silhouette of the part can be caught by the image pickup unit. Subsequently, the center of the silhouette caught by the image pickup unit, i.e. the center of the part, is determined by image processing.

In determining the center of a part as described above, the silhouette of the part itself only must be obtained. However, if the nozzle tip of the suction nozzle protrudes from the part, shadow of the protruded portion of the nozzle tip is included in the silhouette obtained. In such circumstances, the center of the silhouette does not conform to the center of the part, so that the part cannot be mounted on the printed board accurately at the target position.

Recently, since parts are becoming notably smaller, frequency that the nozzle tip protrudes from the part when it is sucked up by the nozzle tip is increasing. In order to eliminate such inconvenience, the diameter of the nozzle tip may be reduced. However, the bore diameter of the nozzle tip cannot be reduced so as to allow the part to be sucked stably by the suction nozzle. Accordingly, if a necessary bore diameter is secured and then the outer diameter of the nozzle tip is reduced, the wall thickness of the nozzle tip becomes small to lower strength of the nozzle tip itself.

### SUMMARY OF THE INVENTION

It is an object of the present invention to provide a suction nozzle device for a work mounting machine, which can certainly grasp the silhouette of a part only with secured nozzle tip strength and which can suitably improve accuracy of mounting the part.

The object of the present invention described above can be attained by a suction nozzle device of the present invention. The suction nozzle device comprises a suction nozzle which travels along a predetermined path and takes up a part from a part feeder to mount the part onto a substrate and which includes a nozzle tip for attracting the part under suction at a distal end thereof, the nozzle tip having a light-permeable transparent portion at least on a periphery of the nozzle tip; and image pickup means for obtaining a silhouette of the part viewed across the part from the nozzle tip in the course that the part taken up by the suction nozzle is transported together with the suction nozzle toward the substrate.

According to the suction nozzle device described above, even if the transparent portion of the nozzle tip protrudes from the part when the part is sucked up by the nozzle tip of the suction nozzle, the protruding transparent portion does not intercept light. Thus, when silhouette of the part is picked up, shadow of the transparent portion protruding from the part is not included in the silhouette. Consequently, the center of the part can be detected accurately based on the silhouette picked up, and thus part mounting accuracy is improved.

The nozzle tip may includes a metal inner pipe and a transparent outer pipe surrounding the inner pipe. In this case, even if the wall thickness of the inner pipe is reduced, sufficient wall thickness of the entire nozzle tip can be secured by the outer pipe. Further, the nozzle tip may be entirely made of a transparent material. The transparent portion of the nozzle tip preferably has at least one of abrasion resistance and shock resistance. Thus, abrasion or damage of the nozzle tip to be caused when the nozzle tip is abutted against parts to suck up the parts can be reduced.

The image pickup means may include a light source, and the suction nozzle may further includes reflecting means for receiving light emitted from the light source and reflects it from the nozzle tip side toward the part sucked up by the nozzle tip. A merit in this case is that there is no need of providing a light source on the suction nozzle side.

Typically, the reflecting means includes a first reflecting surface provided on the nozzle tip side and a second reflecting surface, having a diameter greater than that of the first reflecting surface, provided on the proximal end side of the suction nozzle. In this case, even if a part which is larger than the first reflecting surface is sucked up by the nozzle tip, the silhouette of the part can be picked up based on the light reflected by the second reflecting surface.

### BRIEF DESCRIPTION OF THE DRAWINGS

The present invention will be more fully understood from the detailed description given herein below and the accompanying drawings which are given by way of illustration only, and thus, are not limitative of the present invention, wherein:
Fig. 1 is a perspective view schematically showing a chip mounter;
Fig. 2 is a front view of an image pickup unit which catches the silhouette of a part;
Fig. 3 is a cross-sectional view of an irradiation ring shown in Fig. 2 together with a suction nozzle;
Fig. 4 shows a sucking position of the nozzle tip with respect to a part;
Fig. 5 shows silhouette of the part in the state shown in Fig. 4;
Fig. 6 shows another sucking position of the nozzle tip with respect to a part;
Fig. 7 shows silhouette of the part in the state shown in Fig. 6;
Fig. 8 shows another sucking position of the nozzle tip with respect to a part;
Fig. 9 shows silhouette of the part in the state shown in Fig. 8;
Fig. 10 shows in cross-sectional view a variation of the nozzle tip; and
Fig. 11 shows a sucking position of the nozzle tip shown in Fig. 10 with respect to a part.

### DETAILED DESCRIPTION OF THE PREFERRED EMBODIMENTS

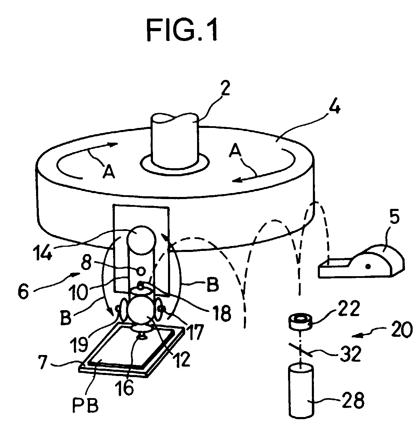

Referring to Fig. 1, a work mounting machine or so-called chip mounter has a rotary shaft 2 which extends in the vertical direction. The lower end portion of the rotary shaft 2 is connected to a driving motor (not shown). A horizontal head drum 4 is attached to the rotary shaft 2 and is rotated together with the rotary shaft 2 at a predetermined speed in the direction of the arrow A shown in Fig. 1.

A plurality of head assemblies 6 are attached to the circumference of the head drum 4 at equal intervals in the circumferential direction. In Fig. 1, only one head assembly 6 is shown. The head assembly 6 has a pivot 8 which is horizontally extended radially in the head drum 4. A link arm 10 is attached to the outer end of the pivot 8 to be extended to each side in the diametrical direction of the pivot 8 and to have two end portions which are at equal distance from the pivot 8. The inner end portion of the pivot 8 is connected to the driving motor via a power transmitting system (not shown). Accordingly, with the rotation of the head drum 4, the pivot 8, i.e. the link arm 10 is also rotated. It should be noted here that the link arm 10 is rotated such that the rotational direction of one end of the link arm 10 may be opposite to the rotational direction of the head drum 4 when the former passes along the lower half of its turning orbit locating below the pivot 8.

A round nozzle head 12 is attached vertically to one end portion of the link arm 10 to be rotatable around its axis. A balance weight 14 is attached to the other end portion of the link arm 10. The balance weight 14 and the nozzle head 12 are of the same weight. Four suction nozzles 16 to 19 protrude from the periphery of the nozzle head 12 at equal intervals in the circumferential direction. Of these four nozzles 16 to 19, one nozzle 16 directing downward can be connected as an active nozzle either to a suction line or to a blow line. The suction line and the blow line are not shown in Fig. 1. Other suction nozzles 17 to 19 are spare or stand-by nozzles. When the nozzle head 12 is rotated by 90° to allow one of the suction nozzles 17 to 19 to direct downward, that nozzle (17, 18 or 19) becomes an active nozzle in place of the suction nozzle 16. Switching over to the active nozzle is determined by the size of the electronic or electric part to be sucked up by the suction nozzle.

The pivot 8 and the nozzle head 12 are connected to each other via a belt-type planetary mechanism (not shown). When the link arm 10 is rotated together with the pivot 8, the nozzle head 12 is turned around the pivot 8 in the direction of the arrow B shown in Fig. 1. In this turning of the nozzle head 12, the planetary mechanism functions to maintain the nozzle head 12 in a fixed posture. More specifically, the suction nozzle 16 is maintained to direct downward during turning of the nozzle head 12.

Meanwhile, when the head drum 4 is rotated, the nozzle head 12 makes revolution along a circular transportation path around the rotary shaft 2. When this revolution is combined with the turning of the nozzle head 12, the nozzle head 12 or the lower end of the suction nozzle 16 moves in the circumferential direction of the head drum 4 repeating vertical movement. In other words, the lower end of the suction nozzle 16 moves along the transportation path repeating a cycloid motion, in which the bottom dead point of the lower end of the suction nozzle 16 is positioned on the transportation path. It should be noted here that, if the revolving speed coincides with the turning speed at the lower end of the suction nozzle 16, the ground speed of the lower end becomes zero when it reaches the bottom dead point in the cycloid motion.

A plurality of part feeders 5 are arranged below the head drum 4 along the transportation path of the nozzle head 12 to be adjacent to one another. Each part feeder 5 has a part supplying position situated on the transportation path. Each of the part feeder 5 has a function of feeding a new part to the part supplying position after one part is taken up from that position. Only one part feeder 5 is shown in Fig. 1.

Further, an XY table 7 is disposed below the head drum 4 to be spaced in the circumferential direction of the head drum 4 from the zone where a group of part feeders 5 are located. A printed board PB is loaded on the XY table 7 such that the upper surface of the printed board PB may be located slightly below the level of the transportation path.

During the cycloid motion of the suction nozzle 16 as described above, the lower end of the suction nozzle 16 is positioned at the part supplying position of a selected part feeder 5 with the ground speed of 0. When a suction pressure is supplied to the suction nozzle 16 with such timing, the suction nozzle 16 sucks a part locating at the part supplying position to take it up to its lower end from the selected part feeder 5. Subsequently, the part sucked up by the suction nozzle 16 is transported together with the suction nozzle 16 toward the printed board PB. The lower end of the suction nozzle 16 is positioned above the printed board PB with the ground speed of 0, and a blowing pressure is supplied to the suction nozzle 16 in place of the suction pressure with such timing. Thus, the part sucked up by the suction nozzle 16 is released to be securely mounted on the printed board PB at a target position thereof. Here, the cycle of the cycloid motion of the suction nozzle 16, i.e. the turning speed of the nozzle head 12, is variably controlled temporarily so as to position the bottom dead point of the lower end of the suction nozzle 16 at the part supplying position of the selected part feeder 5. Further, the target position on the printed board PB is preliminarily positioned on the transportation path with the aid of the XY table 7. Incidentally, basic structure and operation of the chip mounter described above are described in U.S. Patent No. 5,417,542.

As shown in Fig. 1, an image pickup unit 20 is disposed below the head drum 4 or below the transportation path to be located between the zone where the group of part feeders 5 are arranged and the printed board PB with respect to the rotational direction of the head drum 4. When a part sucked up by the suction nozzle 16 passes over the image pickup unit 20, or when the part reaches the bottom dead point in the cycloid motion above the image pickup unit 20, the unit 20 catches silhouette of the part.

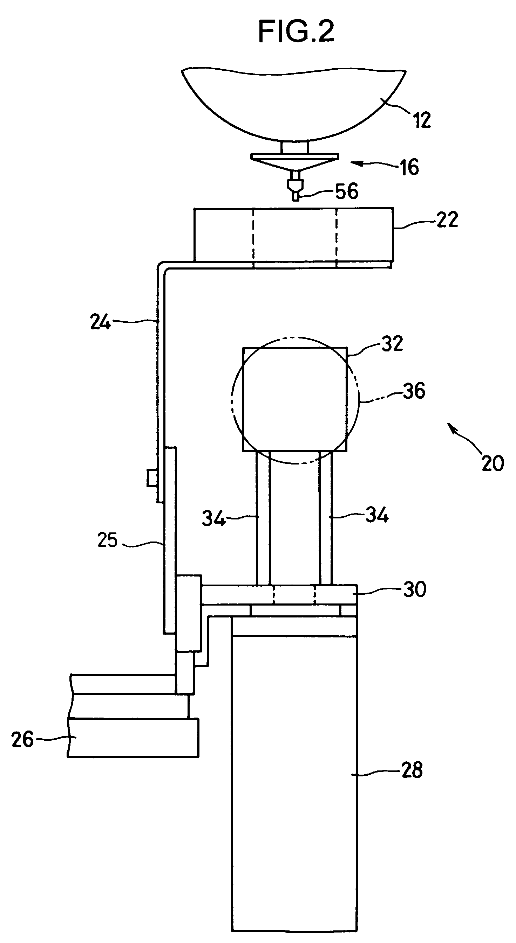

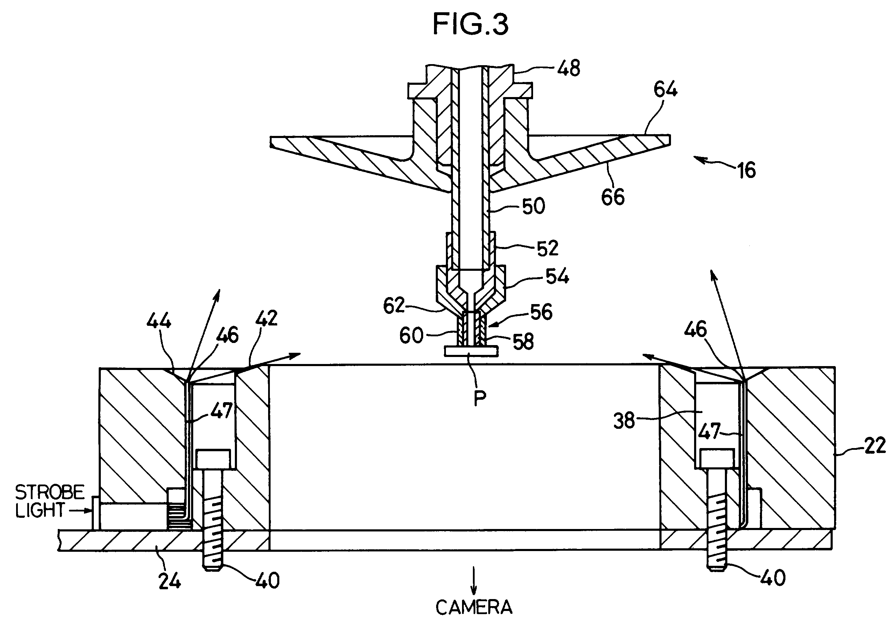

In Figs. 2 and 3, details of the image pickup unit 20 are shown. The image pickup unit 20 has an irradiation ring 22 which is situated immediately below the transportation path. In other words, the irradiation ring 22 is positioned at a level slightly lower than the bottom dead point of the suction nozzle 16. The irradiation ring 22 is attached to the upper surface of an L-shaped fitting plate 24. The lower end portion of the fitting plate 24 is supported via a bracket 25 on a base 26 of the chip mounter. A CCD (charge coupled device) type camera 28 attached to the lower surface of another fitting plate 30 is disposed below the irradiation ring 22. This fitting plate 30 is also supported via the bracket 25 on the base 26. The camera 28 has a lens (not shown) facing upward.

A half mirror 32 is situated between the camera 28 and the irradiation ring 22. The half mirror 32 is supported by the fitting plate 30 via a pair of supporting rods 34 to be slanted by 45° with respect to the horizontal plane. Light emitted from the side of the irradiation ring 22 toward the half mirror 32 is partly transmitted through the half mirror 32 to enter the lens of the camera 28 and partly reflected by the half mirror 32 in the horizontal direction. The reflected light enters a lens of another camera 36. The camera 36 and the camera 28 are of the same type, but they have different image pickup power values. In Fig. 2, the camera 36 is shown by the two-dot chain line only. The cameras 28 and 36 are electrically connected to an image processing unit (not shown) and are selectively used depending on the size of part to be sucked up by the suction nozzle 16.

As shown in Fig. 3, an annular groove 38 is defined on the upper surface of the irradiation ring 22, and a plurality of fixing bolts 40 are disposed at the bottom of the groove 38. These fixing bolts 40 penetrate the irradiation ring 22 and are screwed into the fitting plate 24.

The inner edge and the outer edge of the opening of the groove 38 are tapered to form annular slanted faces 42 and 44, respectively as shown by the two-dot chain line only in Fig. 3. The lower extremity of the outer slanted face 44 defines an annular light emitting section 46. Specifically, a multiplicity of optical fibers 47 are accommodated in the irradiation ring 22, and distal end portions of these fibers 47 are arranged adjacent to one another along the lower extremity of the slanted face 44. The proximal end portions of the optical fibers 47 are bound together into a bunch and are optically connected to a light connector 45. The outer end of the light connector 45 exposes itself on the circumference of the irradiation ring 22, and a strobe light is connected to that end.

In Fig. 3, the lower portion of the suction nozzle 16 is depicted in detail. The suction nozzle 16 has a hollow nozzle shaft 48 protruding from the nozzle head 12. The nozzle shaft 48 is rotatable on its axis. The nozzle shaft 48 has an air pipe 50 therein, and the lower end portion of the air pipe 50 protrudes downward from the nozzle shaft 48. The upper end of the air pipe 50 is connected to an air line in the inside of the nozzle head 12, and the air line is adapted to be connected selectively either to the suction line or the blow line described above.

The lower end portion of the air pipe 50 is screwed into a connector pipe 52. The connector pipe 52 is reduced at the lower end portion to have a tapered lower end. A pipe-like nozzle tip 56 is connected to the lower end portion of the connector pipe 52 via a retainer 54. The upper end portion of the nozzle tip 56 is screwed into the lower end portion of the retainer 54, and the inner space of the nozzle tip 56 communicates via the connector pipe 52 to the air pipe 50. The nozzle tip 56 comprises a metal inner pipe 58 and a transparent outer pipe 60 surrounding the inner pipe 58. The outer pipe 60 is made of a transparent synthetic resin having excellent abrasion resistance and shock resistance, such as polycarbonates, ultra-high-molecular-weight polyethylenes and polyamides (Nylon). While the inner pipe 58 has an inner diameter sufficient to suck up parts, it has small wall thickness. However, since the inner pipe 58 is surrounded by the outer pipe 60, sufficient entire wall thickness or strength of the nozzle tip 56 itself is secured.

More specifically, the upper end of the inner pipe 58 protrudes over the upper end of the outer pipe 60, and the protruded portion of the inner pipe 58 is screwed into the retainer 54. The lower end of the inner pipe 58 and that of the outer pipe 60 are on the same plane, so that the lower end face of the nozzle tip 56 can be conveniently brought into intimate contact with parts. The bore diameter and the outer diameter of the nozzle tip 56, i.e. the bore diameter of the inner pipe 58 and the outer diameter of the outer pipe 60 are determined depending on the size of parts to be sucked, so that the outer pipe 60 has a sufficient wall thickness in stably securing intimate contact with the parts.

As clearly shown in Fig. 3, the lower end portion of the retainer 54 is tapered to define a male engagement portion, and the maximum outer diameter of the tapered surface thereof is sufficiently greater than the outer diameter of the nozzle tip 56. Further, the tapered surface of the retainer 54 constitutes a reflecting surface 62. The upper end face of the outer pipe 60 is tapered to define a female engagement portion which matches with the lower end of the reflecting surface 62.

A reflecting cone 64 is attached to the lower portion of the nozzle shaft 48 to face downward. The lower surface of the reflecting cone 64 constitutes a tapered reflecting surface 66, and the reflecting surface 66 has a maximum outer diameter sufficiently greater than that of the retainer 54.
As described above, a part sucked up to the lower end of the suction nozzle 16 or the nozzle tip 56 is transported together with the suction nozzle 16 from the part feeder 5 toward the printed board PB. In this transportation process, the nozzle tip 56 is positioned at the bottom dead point, where the ground speed becomes 0, above the center of the irradiation ring 22. With this timing, light is emitted from the strobe light to be irradiated upward from the light emitting section 46 of the irradiation ring 22.

Since the irradiation ring 22 itself serves as a light intercepting member, the light irradiated through the light emitting section 46 is prevented from impinging directly upon the part P sucked up by the nozzle tip 56. However, the irradiated light is reflected downward by the reflecting surface 66 of the reflecting cone 64 and the reflecting surface 62 of the retainer 54 respectively. The reflected light is partly transmitted through the opening of the ring 22 and the half mirror 32 to enter the lens of the camera 28. It should be noted here that the reflected light is partly intercepted by the part P before it enters the lens of the camera 28, so that the camera 28 can pick up the silhouette of the part P. In the case where the part P is small as shown in Fig. 3, the part P intercepts the light reflected by the reflecting surface 62. However, in the case where the part P is large, it intercepts not only the light reflected by the reflecting surface 62 but also the light reflected by the reflecting surface 66 of the reflecting cone 64.

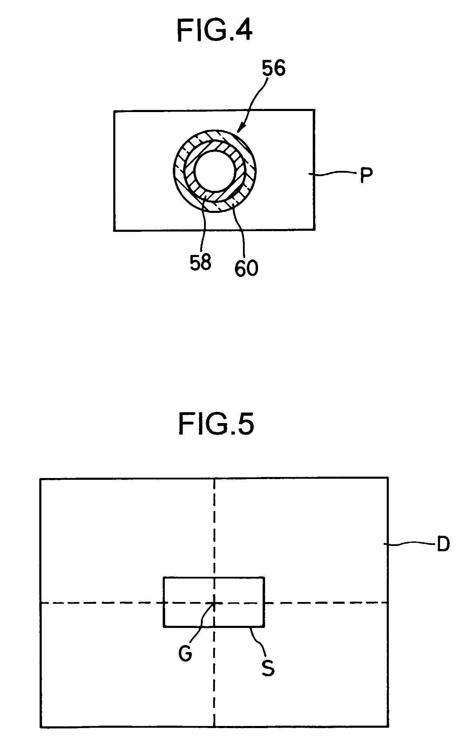

As shown in Fig. 4, when the nozzle tip 56 is sucking up the part P at the center, the silhouette S picked up by the camera 28 appears on a display D of the image processing unit as shown in Fig. 5. The image processing unit operates to determine the center of gravity G (center of the part P) in the area of the silhouette S and then operates to determine deviation of the center of gravity G from the axis of the nozzle tip 56. For example, the position of the center of gravity G of the silhouette S is indicated by a solid cross pointer, whereas the axis of the nozzle tip 56 is indicated by a broken cross cursor on the display D. As described above, when the part P is sucked up by the nozzle tip 56 at the center thereof, the center of gravity G of the silhouette S conforms with the axis of the nozzle tip 56, so that there is no deviation between the center of gravity G and the axis of the nozzle tip 56.

If deviation of the center of gravity G of the silhouette S from the axis of the nozzle tip 56 appears in the image processing unit, driving of the XY table 7 is corrected based on the deviation and the direction of deviation. Specifically, when the part P is to be mounted on the printed board PB at a target position, positioning of the target position with respect to the transportation path for the nozzle tip 56 is corrected so as to bring the center of gravity G of the part P in alignment with the target position.

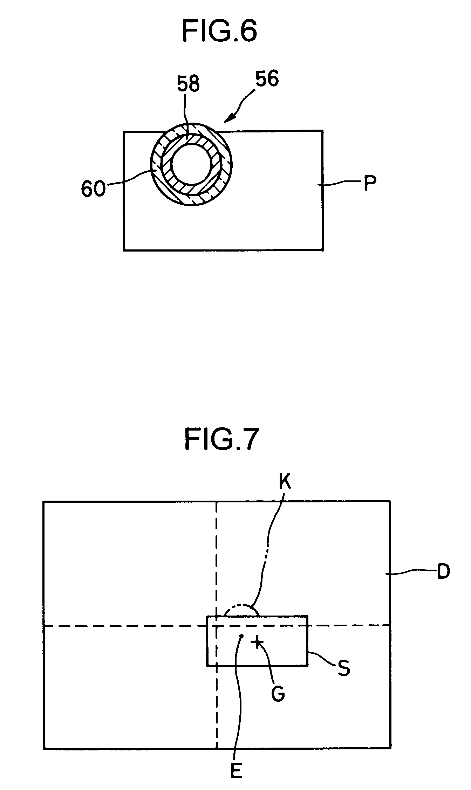

As shown in Fig. 6, when the part P is sucked up by the nozzle tip 56 at a position deviated from the center thereof and the outer pipe 60 of the nozzle tip 56 is protruding partly from the part P, the reflected light is transmitted through the protruded portion of the outer pipe 60 to enter the lens of the camera 28, because the outer pipe 60 is transparent. Accordingly, shadow of the protruded portion of the outer pipe 60 is not included in the silhouette S, and the silhouette S indicated by the solid line in Fig. 7 accurately shows the profile of the part P. If the driving control of the XY table 7 is corrected based on the deviation of the center of gravity G of the silhouette S from the axis of the nozzle tip 56 and the direction of deviation even in such cases, the part P can be mounted on the printed board PB accurately at the target position.

However, if the outer pipe 60 is made of a nontransparent material like the inner pipe 58, the portion of the outer pipe 60 protruding from the part P intercepts the reflected light, so that the shadow K corresponding to the protruded portion of the outer pipe 60 is included in the silhouette S of the part P appeared on the display D as depicted by the two-dot chain line in Fig. 7.

Even if the center of gravity E is determined from the area of the silhouette S including the shadow K as described above, the center E of gravity E does not conform with the center (G) of the part P. Accordingly, even if the driving control of the XY table 7 is corrected based on the deviation of the center of gravity E from the axis of the nozzle tip 56 and the direction of deviation, the part P cannot be mounted accurately on the printed board PB at the target position.

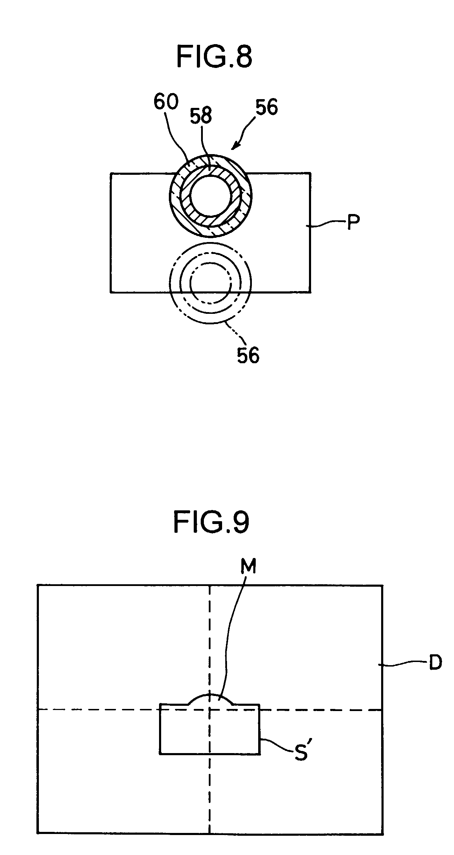

As shown in Fig. 8, in the case where the part P is sucked up by the nozzle tip 56 at a position greatly deviated from the center of the part P and not only the outer pipe 60 but also the inner pipe 58 are protruding from the part P, the shadow M corresponding to the protruded portion of the inner pipe 58 is included in the silhouette S' of the part P as shown in Fig. 9. Even if the center of gravity of the silhouette S' including the shadow M is determined, the thus determined center of gravity does not conform with the center of the part P. Therefore, the part P should not be mounted in such cases but an error signal informing that the part P is not properly sucked up is output from the image processing unit.

More specifically, a reference silhouette of the part P is preliminarily stored in the image processing unit, and the unit compares the reference silhouette with the actual silhouette of the part P picked up by the camera by means of pattern recognition. When the actual silhouette does not conform with the reference silhouette as a result of comparison, the image processing unit outputs an error signal.
If the chip mounter receives the error signal output from the image processing unit, it does not execute the motion of mounting the part P onto the printed board PB. That is, the suction nozzle 16 sucking the part P passes as such over the printed board PB, and then a blowing pressure is supplied to the suction nozzle 16. Consequently, the part P sucked up by the suction nozzle 16 is blown away into a recovery box (not shown) by the air blown out of the nozzle tip 56.

If the suction port of the suction nozzle 16 or of the nozzle tip 56 is partly protruding from the part P, as depicted by the two-dot chain line in Fig. 8 when a part P is to be taken up from the selected part feeder 5, the nozzle tip 56 cannot suck up the part P. In such circumstances, the camera 28 picks up the silhouette of the inner pipe 58 of the nozzle tip 56. In this case again, the actual silhouette does not conform with the reference silhouette, so that the image processing unit outputs an error signal to the chip mounter. Further, if the part P is turned when it is taken up from the selected part feeder 5 and sucked up by the nozzle tip 56, the image processing unit operates to determine the rotation angle of the actual silhouette of the part P with respect to the axis of the nozzle tip 56 and outputs an angle signal corresponding to the rotation angle. Upon receipt of the angle signal, the chip mounter turns the nozzle shaft 48 of the suction nozzle 16 around its axis based on the angle signal, and thus the posture of the part P is corrected to the regular posture.

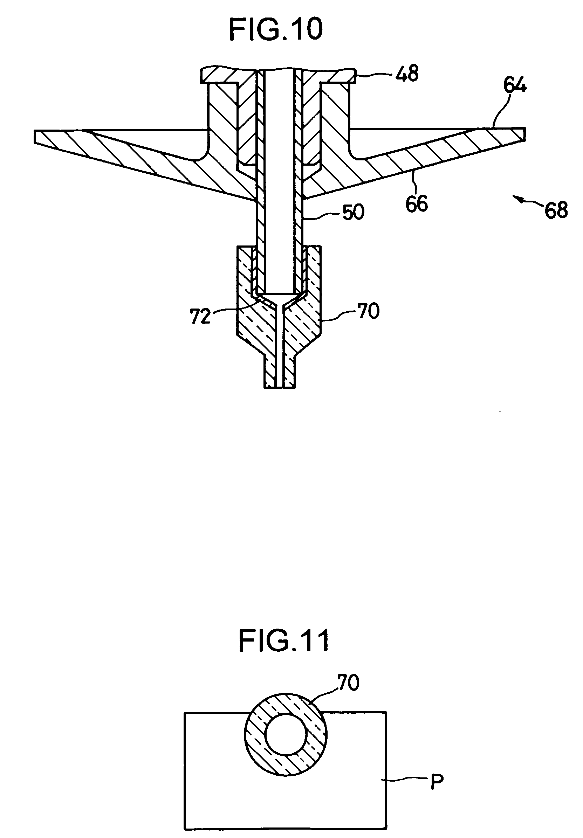

In Fig. 10, another suction nozzle 68 is shown. This suction nozzle 68 is different from the suction nozzle 16 in the structure of the lower end portion. In the suction nozzle 68, a nozzle tip 70 is directly attached to the lower end portion of the air pipe 50. The nozzle tip 70 is entirely made of a transparent material like the outer pipe 60 and has a reduced lower end portion. The nozzle tip 70 has a hole at the upper end face in which the lower end portion of the air pipe 50 is inserted. The bottom of this hole is tapered. A coating is applied to the tapered bottom surface to form a reflecting layer 72 which functions the same as the reflecting surface 62 of the nozzle tip 56 does.

The nozzle tip 70 of the suction nozzle 68 is entirely transparent, so that if the nozzle tip 70 sucks up a part P in the state where the nozzle tip 70 is partly protruding from the part P as shown in Fig. 11, no shadow attributed to the protruded portion of the nozzle tip 70 is included in the actual silhouette of the part P. Accordingly, the center of gravity determined from the actual silhouette conforms accurately with the center of the part P.

Although only two embodiments of the present invention have been described herein, it should be apparent to those skilled in the art that the present invention may be embodied in many other specific forms without departing from the spirit or scope of the invention. Therefore, the present examples and embodiments are to be considered as illustrative and not restrictive, and the invention is not to be limited to the details given herein, but may be modified within the scope of the appended claims.

## Claims

1. A suction nozzle device for a work mounting machine, comprising a suction nozzle (16:68) which travels along a predetermined path and takes up a part (P) from a part feeder (5) to mount the part (P) onto a substrate (PB) and which includes at a distal end thereof a nozzle tip (56) for taking up the part (P) under suction, and image pickup means (20) for obtaining a silhouette of the part (P) in the course that the part (P) taken up by said suction nozzle (16:68) is transported together with said suction nozzle (16:68) toward the substrate (PB),
characterized in that the nozzle tip (56) comprises a light-permeable transparent portion (60:70) at least on a periphery thereof.

2. The device according to claim 1,
characterized in that the nozzle tip (56) comprises a metal inner pipe (58) and an outer pipe (60) as the transparent portion surrounding the inner pipe (58).

3. The device according to claim 1,
characterized in that the nozzle tip (70) is entirely light permeable.

4. The device according to claim 2 or 3,
characterized in that the transparent portion is of a material having abrasion resistance.

5. The device according to claim 2 or 3,
characterized in that the transparent portion is of a material having shock resistance.

6. The device according to claim 4,
characterized in that the transparent portion also has shock resistance.

7. The device according to claim 2 or 3,
characterized in that said image pickup means (20) includes a light source (22), and said suction nozzle (16:68) further includes reflecting means (62,66:72,66) which receives light from the light source (2) and reflects the light from the nozzle tip side toward the part (P).

8. The device according to claim 7,
characterized in that the reflecting means includes a first reflecting surface (62:72) provided on the nozzle tip side and a second reflecting surface (66), having a diameter greater than that of said first reflecting surface (62:72), provided on a proximal end side of said suction nozzle (16:68).
